# EUROPEAN PATENT SPECIFICATION

(11) **EP 1 992 022 B1**
(45) Date of publication and mention of the grant of the patent: **08.04.2015**
(21) Application number: 07734888.6
(22) Date of filing: 14.02.2007
(51) Int. Cl.: H01L 41/053, F02M 51/06

(54) **ENCAPSULATING ARRANGEMENT FOR AN ELECTRICAL COMPONENT**
VERKAPSELUNGSANORDNUNG FÜR EINE ELEKTRONISCHE KOMPONENTE
SYSTEME D'ENVELOPPE POUR COMPOSANT ELECTRIQUE

(30) Priority: 06.03.2006 GB 0604467; 05.05.2006 GB 0608944
(43) Date of publication of application: 19.11.2008
(73) Proprietor: Delphi International Operations Luxembourg S.à r.l., 4940 Bascharage (LU)
(72) Inventor: BOSCH, Russell, Gaines, MI 48436 (US); BERLEMONT, Jean-François, B-1780 Wemmel (BE)
(74) Representative: Neill, Andrew Peter
(86) International application number: PCT/IB2007/001705
(87) International publication number: WO 2007/102088

(56) References cited:
- EP-A1- 0 995 901
- JP-A- 1 137 686
- JP-A- 2 094 680
- JP-A- 3 203 383
- JP-A- 4 303 978
- JP-A- 5 275 765

## Description

### Technical Field

The invention relates to an encapsulating arrangement for use in protectively coating an electrical component. In particular, though not exclusively, the invention relates to an encapsulating arrangement for a piezoelectric actuator of an automotive fuel injector.

### Background to the Invention

Automotive equipment manufacturers are under constant pressure to improve the fuel efficiency of diesel engines and to reduce harmful exhaust gases in order to lessen the environmental impact of their vehicles.

A key part of meeting this challenge is the development of piezoelectric fuel injectors. In an automotive engine, such a fuel injector is used to deliver a charge of fuel into an associated combustion cylinder. Typically, an engine will include several such cylinder and injector pairs - usually four, six or eight. A piezoelectric fuel injector offers precise controllability of the amount of fuel delivered into its associated combustion cylinder and, as such, is particularly suited to the demands of a diesel engine.

In some piezoelectric injectors, a piezoelectric actuator is housed in a fuel filled chamber defined within the injector such that the actuator is surrounded by liquid fuel at high pressure, typically between 200 and above 2000 bar. An injector of this type is described, for example, in the Applicant's European Patent No. 995901.

Although locating the piezoelectric actuator within such a fuel filled chamber is beneficial for several reasons, such an arrangement has associated drawbacks. In particular, the fuel surrounding the actuator contains injurious components that are capable of damaging the actuator if it is not adequately protected.

In one particular piezoelectric actuator arrangement, described in JP 4 303978 A, a single deposited resin layer having an embedded metal layer is used to clad an electrode of the piezoelectric actuator in order to prevent water from reaching the surface of the piezoelectric material.

The invention is therefore directed to improving the protection of electrical components, particularly piezoelectric actuators, from chemically aggressive environments in which they may be disposed, in use.

### Summary of the Invention

Against this background, the invention provides an encapsulating arrangement for an electrical component, the encapsulating arrangement comprising first and second insulating layers and an electrically charged conductive layer disposed intermediate the first and second layers to prevent the passage of ionic species across the encapsulating arrangement, and in which the conductive layer is discontinuous.

It is preferred that the first and second insulating layers are polymeric materials to provide good electrical insulation and good resistance to chemical attack from the environment in which the electrical component is located, in use. However, the use of polymeric material, exclusively, is not essential to the invention.

Although the invention is applicable to encapsulating electronic components in general, especially if they are required to operate in chemically aggressive environments, the invention conveys particular benefits in the context of piezoelectric actuators of automotive fuel injection equipment.

In this context, it is known to encapsulate piezoelectric actuators in polymeric material in order to protect the actuators from moisture bearing environments. For example, in the injector described in the Applicant's European Patent No. 995901, the piezoelectric actuator is immersed in a pressurised fuel volume defined within the injector body.

However, although a polymeric insulating layer is relatively adept at protecting the actuator from high pressure fluids, it is possible that ionic species are able to permeate the insulating layer and cause damage to the stack. The electrically charged conductive layer of the invention therefore provides an ionic diffusion barrier to prevent the transport of ionic species present as contaminants, in fuel for instance, that may otherwise come into contact with an encapsulated electrical component.

It is preferable that the conductive layer is a metal. Any suitable metal can be used to form the conductive layer, such as copper, aluminium, iron, steel, nickel, cobalt, silver, gold or an alloy thereof.

It will be appreciated that the metal should remain in a solid state over the operating temperature range of the electrical component to be encapsulated.

More particularly, it is preferred that the conductive layer is a self-supporting, or self-standing, metal foil. A self-supporting metal foil is advantageous in that it is a cost effective means to provide the actuator with an ionic barrier and is relatively simple to manufacture by wrapping the foil around the component. The metal foil may be in the form of a wide sheet having a width comparable to the length of the actuator, or in the form of a relatively narrow band or tape, in which case it may be wrapped helically around the stack, either in a single layer, or in an overlapped manner in order to provide a layer of increased thickness.

In an alternative embodiment, the conductive layer is a metallic film that is carried on a non-conductive self-supporting substrate such as a polymer membrane or film to form a composite. In a further embodiment of the invention the conductive layer may be formed directly onto the first or second non-conductive layers via techniques known in the art such as vapour deposition, electroless plating, electroplating or sputtering.

Such a metallic film provides a conductive layer of reduced thickness compared with a self-supporting metal foil, which may be advantageous in terms of packaging the electronic component in a confined space.

The conductive layer is discontinuous: in other words, the physical coverage of the conductive layer over the surface of the electrical component is intermittent. The discontinuous conductive layer may therefore be in the form of a wrapping, or a mesh, net, grid or foam, for example.

In a second aspect, the invention provides an electrical component that is protected by an encapsulating arrangement as described above. Preferably, the electrical component is a piezoelectric device in the form of an actuator for use within an automotive fuel injector.

The piezoelectric device may include charging means to permit charging of the conductive layer at least during operation of the device. Preferably, the charging means includes an electrical connector arrangement having first and second terminals for supplying an electrical voltage across positive and negative external electrodes of the piezoelectric device. In this embodiment, the charging means further includes connection means to enable electrical connection between the conductive layer and one of the positive or negative external electrodes of the device.

Although the connection between the conductive layer and the external electrode may be provided in many ways, for example a metal connector spanning across the first insulating layer, for simplicity it is preferred that the connection means includes a window defined by the first insulating layer such that the external electrode and the conductive layer are able to contact one another.

In an alternative arrangement, the conductive layer may be connected to a separate voltage source, for example provided by a third terminal through the connector arrangement. A separate means to charge the conductive layer permits greater flexibility in the charging profile provided to the conductive layer. For example, the conductive layer may be arranged to receive constant, or alternating, charging waveforms. A further possibility is for the separate voltage source to be arranged to charge the conductive layer even after the engine ignition has been turned off so as to provide continued ionic protection for the device. To this end, the third terminal may be connected to an uninterruptible power supply, for example the vehicle battery.

In a further alternative embodiment, the conductive layer is connected to an earthed component of the device or may be charged through mutual capacitance with the piezoelectric device.

In a third aspect, the invention provides a fuel injector incorporating a piezoelectric device as described above in relation to the first and second aspects.

In a fourth aspect, the invention provides a piezoelectric device including: an electrical connector arrangement for connecting the device to a power source, first and second external electrodes for generating an electrical field across the device when the device is connected to the power source, in use, wherein the electrical connector arrangement includes first and second electrical terminals connected, respectively, to the first and second external electrodes, and wherein the piezoelectric device is protected by an encapsulating arrangement including first and second separate insulating layers, and a third layer in the form of an electrically charged conductive layer intermediate the first and second insulating layers which is arranged to prevent the passage of ionic species across the encapsulating arrangement, the piezoelectric device further including charging means to permit charging of the conductive layer at least during operation of the piezoelectric device wherein the charging means includes connection means to enable electrical connection between the conductive layer and one of said external electrodes.

The connection means may include a window defined by the first insulating layer.

In a fifth aspect, the invention provides a piezoelectric device including: an electrical connector arrangement for connecting the device to a power source, first and second external electrodes for generating an electric field across the device when the device is connected to the power source, in use, wherein the electrical connector arrangement includes first and second electrical terminals connected, respectively, to the first and second external electrodes; and wherein the piezoelectric device is protected by an encapsulating arrangement including first and second separate insulating layers; and a third layer in the form of an electrically charged conductive layer intermediate the first and second insulating layers which is arranged to prevent the passage of ionic species across the encapsulating arrangement, the piezoelectric device further including charging means to permit charging of the conductive layer at least during operation of the piezoelectric device wherein the charging means is a third terminal provided by the electrical connector arrangement that is in electrical contact with the conductive layer.

The third terminal may be provided with a connection to an uninterruptible power supply to enable charging of the conductive layer in circumstances when the first and second electrical terminals are inoperative.

### Brief Description of the Drawings

Figure 1 is a perspective view of a known piezoelectric actuator stack; and
Figure 2 is a sectional view of the actuator of Figure 1 along the line A-A being provided with an encapsulating arrangement in accordance with an embodiment of the invention.

### Detailed Description of the Preferred Embodiments

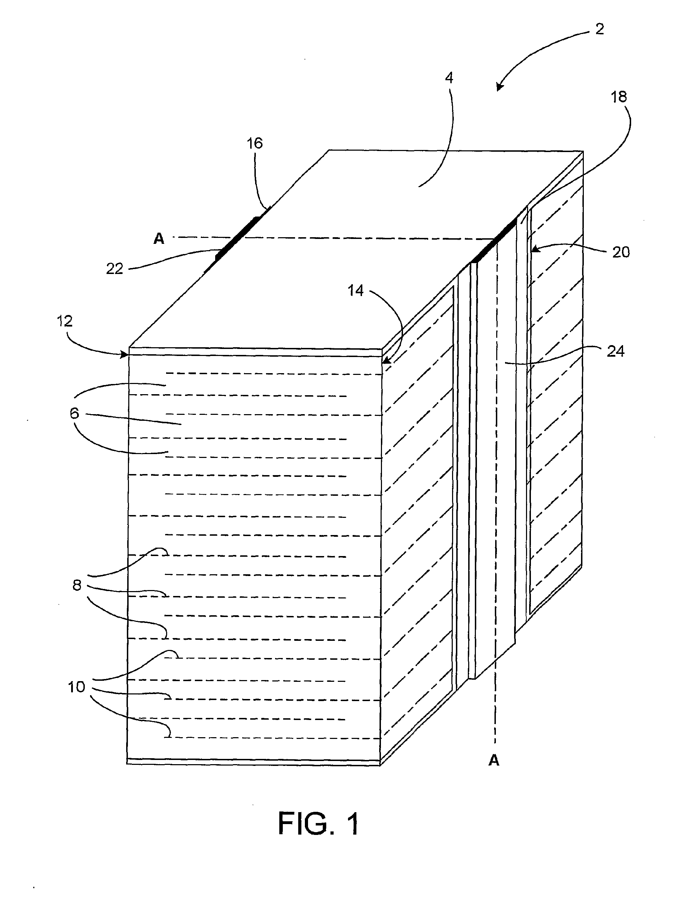

Referring to Figure 1, a known piezoelectric device in the form of an actuator arrangement 2 includes a piezoelectric stack 4 comprising a plurality of layers 6 formed of a ferroelectric material, for example Lead Zirconate Titonate (PZT). Each layer 6 is separated from its adjacent layer or layers within the stack 4 by internal electrodes 8, 10 that are interdigitated with the piezoelectric layers 6 so as to form an alternating sequence of positive and negative internal electrodes 8, 10, respectively. Each adjacent pair of positive and negative internal electrodes 8, 10 therefore sandwiches a respective piezoelectric layer 6, which exhibits a mechanical strain in response to a voltage applied across the positive and negative internal electrodes 8, 10.

Each positive internal electrode 8 terminates at a positive face 12 of the stack 4 and each negative internal electrode 10 terminates at a negative face 14 of the stack 4. The positive and negative faces 12, 14 of the stack 4 bear respective positive and negative metallised regions 16, 18 that extend across a portion of the stack surface such that the positive metallic region 16 electrically connects the positive internal electrodes 8 and the negative metallised region 18 electrically connects the negative internal electrodes 10.

The stack 4 is also provided with an electrical passivation layer 20 that covers substantially the entire surface of the stack 4, except for the positive and negative metallic regions 16, 18. The function of the passivation layer 20 is to insulate the edges of the internal electrodes 8, 10 that emerge at the stack surface and so guard against surface flashovers due to the high voltages applied to the internal electrode layers 8, 10. A suitable material for the passivation layer 20 is a polyimide film such as Kapton™ by DuPont due to its high dielectric strength yet low thickness and weight.

In order to enable supply of an electrical voltage to the internal electrodes 8, 10 of the stack 4, a positive external electrode 22 is attached to the positive metallised region 16 and a negative external electrode 24 is attached to the negative metallised region 18. In use, the positive and negative external electrodes 22, 24 are connected to a power source via a connector module (not shown) mounted atop the stack 4 by which means a variable voltage is applied to the positive and negative internal electrodes 8, 10 to control expansion and contraction of the stack 4.

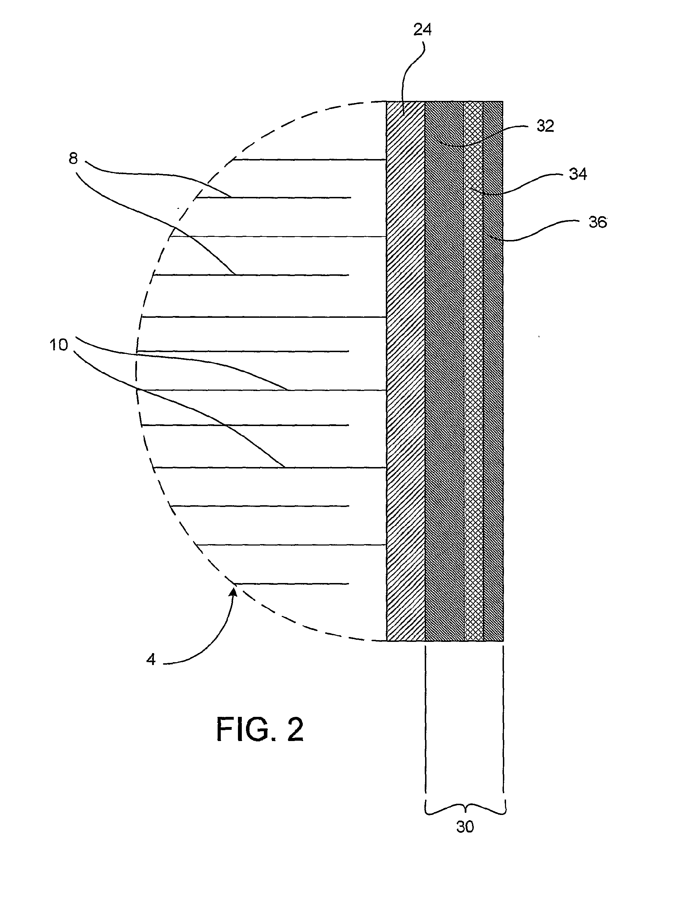

Figure 2 shows a sectional view of the stack 4 of Figure 1 bearing a multi-layered encapsulating arrangement 30 in accordance with an embodiment of the invention. It should be appreciated that the scale of the stack 4 and the encapsulating arrangement 30 shown in Figure 2 is greatly exaggerated here for the purposes of clarity. The encapsulating arrangement 30 provides a means of protecting the relatively brittle piezoelectric material of the stack 4 from an aggressive operational environment.

In this embodiment, the encapsulating arrangement 30 is a laminated structure comprising three separate encapsulating layers. The first encapsulating layer 32 is an insulating layer that is arranged to completely envelop the surface of the stack 4 and the external electrodes 22, 24 that are exposed to the external environment, in use (only the negative external electrode 24 is shown in Figure 2). It is important that the first insulating layer 32 provides good electrical insulation properties, high strength and high temperature resistance. A suitable material for the first insulating layer 32 is a polymeric material, such as PTFE/ETFE, in the form of a heat-shrinkable self-supporting film or sleeve that contracts upon the application of heat to fit tightly the profile of the stack 4. A standard electrical grade adhesive may be applied to the insulating layer 32 to improve its adhesion to the stack surface.

The second encapsulating layer 34 is an electrically conductive layer that is adapted to be impermeable to the through passage of ionic species. The conductive layer 34 is prevented from contacting the external electrodes 22, 24 by the first insulating layer 32. The conductive layer will be described in further detail later.

The third, and final, encapsulating layer 36 in this embodiment is a second insulating layer that is arranged to completely encapsulate the electrically conductive layer 34, thus serving to insulate the conductive layer 34 from the external environment, in use. As with the first insulating layer 32, a suitable material for the second insulating layer 36 is an organic polymeric material, such as PTFE/ETFE, in the form of a heat-shrinkable self-supporting film or sleeve.

Returning to the electrically conductive layer 34, in this embodiment the conductive layer 34 comprises a self-supporting metal foil, for example aluminium foil, having a thickness of approximately 10µm. In an exemplary realisation not forming part of the invention, the foil layer 34 is wrapped around the stack 4 encapsulated by the first insulating layer 32 to form a substantially continuous, or unbroken, metallic barrier. To ensure good adhesion, adhesive is applied to the ends of the stack 4 to secure the foil layer 34 to the first insulating layer 32. It should be mentioned at this point that other thicknesses of metal foil could also be used, for example above or below 10µm. It is important, however, that the thickness of the metal foil lends itself to convenient application to the stack.

Although not shown in Figure 2, the first insulating layer 32 is provided with a window that exposes a portion of the positive external electrode 24. The positive external electrode 24 therefore contacts the electrically conductive layer 34 in this region by which means the conductive layer 34 is provided with a positive voltage potential. The positively charged conductive layer 34 repels ions of like polarity, in this case anions, whilst attracting and sequestering oppositely charged ions, in this case cations. The conductive layer 34 therefore functions as an ionic shield that prevents ionic species present in the fuel permeating through the encapsulating arrangement 30 and into the structure of the stack 4.

In the preferred embodiment of the invention mentioned above, the conductive layer 34 is connected to the positive terminal of the connector module by contacting the positive external electrode 24 of the stack 4. It should be appreciated, however, that this is just one way of charging the ionic shield and variations are possible within the inventive concept.

For example, the electrically conductive layer 34 may, instead, be connected to the negative terminal of the connector module by contacting the negative external electrode 22 of the stack 4. In this case, the electrically conductive layer 34 would attract anions and repel cations.

Still alternatively, the conductive layer 34 may be connected to a third, dedicated terminal, provided by the connector module for example, though which the conductive layer 34 could be provided with an optimum voltage level adapted specifically for a particular circumstance. For example, in some circumstances it may be preferable to provide the electrically conductive layer 34 with a constant voltage of a predetermined magnitude. Conversely, in other circumstances, it may be preferable to provide the conductive layer 34 with a variable voltage, in the form of a square waveform, or a sinusoidal waveform, for example.

The provision of a dedicated voltage terminal for connecting to the conductive layer 34 provides the advantage that a voltage may still be supplied to the ionic shield after the engine has been shut down. For example, the third terminal could be connected to an uninterruptible power supply, for example the vehicle battery, in circumstances when the engine ignition is off in order to provide a level of residual protection to the stack 4 even when the injectors are not operating.

A further alternative is to connect the conductive layer 34 to an earthed component of the actuator 2, for example a steel end member (not shown) which is in direct contact with earthed components of the injector.

It will be apparent from the above described arrangements that the electrically conductive layer 34 is provided with a connection to either electrical ground or a voltage source. However, in some circumstances, it may be sufficient to omit such an electrical connection such that the electrically conductive layer 34 is charged through mutual capacitance due to the proximity of the conductive layer 34 to the internal electrodes 8, 10, metallised region 16, 18 and external electrodes 22, 24 of the stack. In such an arrangement, the conductive layer 34 is at a floating voltage with respect to the voltage of the injector body in which it is housed. Typically the injector body is at ground potential by virtue of its earthed connection to the engine in which it is installed. There can also be variations in the structure of the electrically conductive layer 34. For example, instead of a self-supporting metal foil, the electrically conductive layer 34 may also take the form of a metallised coating that is applied to a supporting substrate such as a polymer membrane or film to form a composite. The metallic coating may be applied to the supporting substrate via known techniques such as vapour deposition or sputtering. Also, it should be appreciated that the supporting substrate may be the first or second insulating layers 32, 36.

Such a metallic coating will be thinner than a self-supporting metal foil, typically in the range of 50 nm to 10 µm, although this range should not be construed as limiting. A thinner conductive layer 34 achievable by way of a metallic coating has the advantage of minimising the lateral cross section of the encapsulated actuator 2. This is particularly important if the actuator is required to be installed within a relatively small space.

All of the above described exemplary arrangements provide a continuous, or unbroken electrically conductive layer 34 that present a physical, as well as an electrical, barrier to ionic species. However, in an arrangement according to the present invention (not shown), the conductive layer 34 is configured in the form of an open structure, such as a grid, mesh, net or a metal foam. Another alternative is a spaced winding to provide a discontinuous layer, for example a metal tape wound helically around the stack. Such a structure provides the same ion-sequestering advantages as encapsulating the entire stack with a continuous conductive layer 34 but uses less material thus providing a relatively low cost alternative. This advantage is particularly important if higher cost materials are used.

## Claims

1. An encapsulating arrangement (30) for an electrical component comprising:
first and second separate insulating layers (32, 36); and
a third layer in the form of an electrically charged conductive layer (34) intermediate the first and second insulating layers (32, 36) which is arranged to prevent the passage of ionic species across the encapsulating arrangement (30), **characterised in that** the conductive layer (34) is discontinuous.

2. The encapsulating arrangement (30) of claim 1, wherein the conductive layer (34) is a metal.

3. An electrical component protected by an encapsulating arrangement (30) as claimed in any one of the preceding claims.

4. The electrical component of claim 3, wherein the electrical component is a piezoelectric device (2) including charging means to permit charging of the conductive layer (34) at least during operation of the piezoelectric device.

5. The piezoelectric device of claim 4, including an electrical connector arrangement for connecting the device to a power source, first and second external electrodes (22, 24) for generating an electrical field across the device when the device is connected to the power source, in use, and wherein the electrical connector arrangement includes first and second electrical terminals connected, respectively, to the first and second external electrodes (22, 24).

6. The piezoelectric device of claim 5, wherein the electrical connector arrangement is provided with a third terminal in electrical contact with the conductive layer (34), the third terminal being provided with a connection to an uninterruptible power supply to enable charging of the conductive layer (34) in circumstances when the first and second electrical terminals are inoperative.

7. A fuel injector incorporating the piezoelectric device of claim 5 or claim 6.

8. A piezoelectric device including:
an electrical connector arrangement for connecting the device to a power source,
first and second external electrodes (22, 24) for generating an electrical field across the device when the device is connected to the power source, in use,
wherein the electrical connector arrangement includes first and second electrical terminals connected, respectively, to the first and second external electrodes (22, 24),
and wherein the piezoelectric device is protected by an encapsulating arrangement including first and second separate insulating layers (32, 36), and a third layer in the form of an electrically charged conductive layer (34) intermediate the first and second insulating layers (32, 36) which is arranged to prevent the passage of ionic species across the encapsulating arrangement (30), and wherein the conductive layer (34) is discontinuous,
the piezoelectric device further including charging means to permit charging of the conductive layer (34) at least during operation of the piezoelectric device wherein the charging means includes connection means to enable electrical connection between the conductive layer (34) and one of said external electrodes (22, 24).

9. The piezoelectric device of claim 8, wherein the connection means includes a window defined by the first insulating layer (32).

10. A piezoelectric device including:
an electrical connector arrangement for connecting the device to a power source,
first and second external electrodes (22, 24) for generating an electric field across the device when the device is connected to the power source, in use,
wherein the electrical connector arrangement includes first and second electrical terminals connected, respectively, to the first and second external electrodes (22, 24);
and wherein the piezoelectric device is protected by an encapsulating arrangement including first and second separate insulating layers (32, 36); and a third layer in the form of an electrically charged conductive layer (34) intermediate the first and second insulating layers (32, 36) which is arranged to prevent the passage of ionic species across the encapsulating arrangement (30), and wherein the conductive layer (34) is discontinuous,
the piezoelectric device further including charging means to permit charging of the conductive layer (34) at least during operation of the piezoelectric device wherein the charging means is a third terminal provided by the electrical connector arrangement that is in electrical contact with the conductive layer (34).

11. The piezoelectric device of claim 10, wherein the third terminal is provided with a connection to an uninterruptible power supply to enable charging of the conductive layer (34) in circumstances when the first and second electrical terminals are inoperative.

## Patentansprüche

1. Kapselungsanordnung (30) für ein elektrisches Bauteil, umfassend:
eine erste und eine zweite separate isolierende Schicht (32, 36) und
eine dritte Schicht in der Form einer elektrisch geladenen leitfähigen Schicht (34) zwischen der ersten und der zweiten isolierenden Schicht (32, 36), die angeordnet ist, um den Durchgang von ionischen Spezies über die Kapselungsanordnung (30) zu verhüten, **dadurch gekennzeichnet, dass** die leitfähige Schicht (34) nicht kontinuierlich ist.

2. Kapselungsanordnung (30) nach Anspruch 1, wobei die leitfähige Schicht (34) ein Metall ist.

3. Elektrisches Bauteil, das von einer Kapselungsanordnung (30) nach einem der vorhergehenden Ansprüche geschützt wird.

4. Elektrisches Bauteil nach Anspruch 3, wobei das elektrische Bauteil eine piezoelektrische Vorrichtung (2) mit einem Aufladungsmittel ist, um das Laden der leitfähigen Schicht (34), zumindest während des Betriebs der piezoelektrischen Vorrichtung, zuzulassen.

5. Piezoelektrische Vorrichtung nach Anspruch 4 mit einer elektrischen Verbinderanordnung zum Verbinden der Vorrichtung mit einer Stromquelle, einer ersten und einer zweiten Außenelektrode (22, 24) zum Erzeugen eines elektrischen Felds durch die Vorrichtung im Gebrauch, wenn die Vorrichtung mit der Stromquelle verbunden ist, und wobei die elektrische Verbinderanordnung einen ersten und einen zweiten elektrischen Anschluss hat, die mit der ersten bzw. zweiten Außenelektrode (22, 24) verbunden sind.

6. Piezoelektrische Vorrichtung nach Anspruch 5, wobei die elektrische Verbinderanordnung mit einem dritten Anschluss versehen ist, der mit der leitfähigen Schicht (34) in elektrischem Kontakt ist, wobei der dritte Anschluss mit einer Verbindung zu einer unterbrechungsfreien Stromversorgung versehen ist, um das Laden der leitfähigen Schicht (34) unter Umständen zu ermöglichen, wenn der erste und der zweite elektrische Anschluss außer Betrieb sind.

7. Brennstoffeinspritzdüse, in die die piezoelektrische Vorrichtung nach Anspruch 5 oder Anspruch 6 eingebaut ist.

8. Piezoelektrische Vorrichtung, die Folgendes beinhaltet:
eine elektrische Verbinderanordnung zum Verbinden der Vorrichtung mit einer Stromquelle,
eine erste und eine zweite Außenelektrode (22, 24) zum Erzeugen eines elektrischen Felds durch die Vorrichtung im Gebrauch, wenn die Vorrichtung mit der Stromquelle verbunden ist,
wobei die elektrische Verbinderanordnung einen ersten und einen zweiten elektrischen Anschluss hat, die mit der ersten bzw. zweiten Außenelektrode (22, 24) verbunden sind,
und wobei die piezoelektrische Vorrichtung von einer Kapselungsanordnung mit einer ersten und einer zweiten separaten isolierenden Schicht (32, 36) und einer dritten Schicht in der Form einer elektrisch geladenen leitfähigen Schicht (34) zwischen der ersten und der zweiten isolierenden Schicht (32, 36) geschützt wird, die angeordnet ist, um den Durchgang von ionischen Spezies über die Kapselungsanordnung (30) zu verhüten, und wobei die leitfähige Schicht (34) nicht kontinuierlich ist,
wobei die piezoelektrische Vorrichtung des Weiteren ein Aufladungsmittel hat, um das Laden der leitfähigen Schicht (34), zumindest während des Betriebs der piezoelektrischen Vorrichtung, zuzulassen, wobei das Aufladungsmittel ein Verbindungsmittel beinhaltet, um die elektrische Verbindung zwischen der leitfähigen Schicht (34) und einer der genannten Außenelektroden (22, 24) zu ermöglichen.

9. Piezoelektrische Vorrichtung nach Anspruch 8, wobei das Verbindungsmittel ein von der ersten isolierenden Schicht (32) definiertes Fenster beinhaltet.

10. Piezoelektrische Vorrichtung, die Folgendes beinhaltet:
eine elektrische Verbinderanordnung zum Verbinden der Vorrichtung mit einer Stromquelle,
eine erste und eine zweite Außenelektrode (22, 24) zum Erzeugen eines elektrischen Felds durch die Vorrichtung im Gebrauch, wenn die Vorrichtung mit der Stromquelle verbunden ist,
wobei die elektrische Verbinderanordnung einen ersten und einen zweiten elektrische Anschluss hat, die mit der ersten bzw. zweiten Außenelektrode (22, 24) verbunden sind,
und wobei die piezoelektrische Vorrichtung von einer Kapselungsanordnung mit einer ersten und einer zweiten separaten isolierenden Schicht (32, 36) und einer dritten Schicht in der Form einer elektrisch geladenen leitfähigen Schicht (34) zwischen der ersten und der zweiten isolierenden Schicht (32, 36) geschützt wird, die angeordnet ist, um den Durchgang von ionischen Spezies über die Kapselungsanordnung (30) zu verhüten, und wobei die leitfähige Schicht (34) nicht kontinuierlich ist,
wobei die piezoelektrische Vorrichtung des Weiteren ein Aufladungsmittel hat, um das Laden der leitfähigen Schicht (34), zumindest während des Betriebs der piezoelektrischen Vorrichtung, zuzulassen, wobei das Aufladungsmittel ein dritter Anschluss ist, der von der elektrischen Verbinderanordnung bereitgestellt wird, die mit der leitfähigen Schicht (34) in elektrischem Kontakt ist.

11. Piezoelektrische Vorrichtung nach Anspruch 10, wobei der dritte Anschluss mit einer Verbindung zu einer unterbrechungsfreien Stromversorgung versehen ist, um das Laden der leitfähigen Schicht (34) unter Umständen zu ermöglichen, wenn der erste und der zweite elektrische Anschluss außer Betrieb sind.

## Revendications

1. Agencement d'encapsulage (30) pour un composant électrique, comprenant :
une première et une seconde couche isolante séparées (32, 36) ; et
une troisième couche sous la forme d'une couche conductrice électriquement chargée (34) intermédiaire entre la première et la seconde couche isolante (32, 36), qui est agencée pour empêcher le passage d'espèces ioniques à travers l'agencement d'encapsulage (30), **caractérisé en ce que** la couche conductrice (34) est discontinue.

2. Agencement d'encapsulage (30) selon la revendication 1, dans lequel la couche conductrice (34) est un métal.

3. Composant électrique protégé par un agencement d'encapsulage (30) tel que revendiqué dans l'une quelconque des revendications précédentes.

4. Composant électrique selon la revendication 3, dans lequel le composant électrique est un dispositif piézoélectrique (2) incluant des moyens de charge pour permettre la charge de la couche conductrice (34) au moins pendant le fonctionnement du dispositif piézoélectrique.

5. Dispositif piézoélectrique selon la revendication 4, incluant un agencement connecteur électrique pour connecter le dispositif à une source de puissance, une première et une seconde électrode externe (22, 24) pour générer un champ électrique à travers le dispositif quand le dispositif est connecté à la source de puissance, en utilisation, et dans lequel l'agencement connecteur électrique inclut une première et une seconde borne électrique connectées respectivement à la première et à la seconde électrode externe (22, 24).

6. Dispositif piézoélectrique selon la revendication 5, dans lequel l'agencement connecteur électrique est doté d'une troisième borne en contact électrique avec la couche conductrice (34), la troisième borne étant dotée d'une connexion à une alimentation de puissance ininterrompue pour permettre la charge du dispositif conducteur (34) dans des circonstances dans lesquelles la première et la seconde borne électrique ne sont pas opérationnelles.

7. Injecteur de carburant incorporant le dispositif piézoélectrique de la revendication 5 ou 6.

8. Dispositif piézoélectrique incluant :
un agencement connecteur électrique pour connecter le dispositif à une source de puissance,
une première et une seconde électrode externe (22, 24) pour générer un champ électrique à travers le dispositif quand le dispositif est connecté à la source de puissance, en utilisation,
dans lequel l'agencement connecteur électrique inclut une première et une seconde borne électrique connectées respectivement à la première et à la seconde électrode externe (22, 24),
et dans lequel le dispositif piézoélectrique est protégé par un agencement d'encapsulage incluant une première et une seconde couche isolante séparées (32, 36), et une troisième couche sous la forme d'une couche conductrice électriquement chargée (34) intermédiaire entre la première et la seconde couche isolante (32, 36), qui est agencée pour empêcher le passage d'espèces ioniques à travers l'agencement d'encapsulage (30), et dans lequel la couche conductrice (34) est discontinue,
le dispositif piézoélectrique incluant en outre des moyens de charge pour permettre la charge de la couche conductrice (34) au moins pendant le fonctionnement du dispositif piézoélectrique, dans lequel les moyens de charge incluent des moyens de connexion pour permettre une connexion électrique entre la couche conductrice (34) et l'une desdites électrodes externes (22, 24).

9. Dispositif piézoélectrique selon la revendication 8, dans lequel les moyens de connexion incluent une fenêtre définie par la première couche isolante (32).

10. Dispositif piézoélectrique incluant :
un agencement connecteur électrique pour connecter le dispositif à une source de puissance,
une première et une seconde électrode externe (22, 24) pour générer un champ électrique à travers le dispositif quand le dispositif est connecté à la source de puissance, en utilisation,
dans lequel l'agencement connecteur électrique inclut une première et une seconde borne électrique connectées respectivement à la première et à la seconde électrode externe (22, 24) ;
et dans lequel le dispositif piézoélectrique est protégé par un agencement d'encapsulage incluant une première et une seconde couche isolante séparées (32, 36) ; et une troisième couche sous la forme d'une couche conductrice électriquement chargée (34) intermédiaire entre la première et la seconde couche isolante (32, 36), qui est agencée pour empêcher le passage d'espèces ioniques à travers l'agencement d'encapsulage (30), et dans lequel la couche conductrice (34) est discontinue,
le dispositif piézoélectrique incluant en outre des moyens de charge pour permettre la charge de la couche conductrice (34) au moins pendant le fonctionnement du dispositif piézoélectrique, dans lequel les moyens de charge sont constitués par une troisième borne procurée par l'agencement connecteur électrique qui est en contact électrique avec la couche conductrice (34).

11. Dispositif piézoélectrique selon la revendication 10, dans lequel la troisième borne est dotée d'une connexion à une alimentation de puissance ininterrompue pour permettre la charge de la couche conductrice (34) dans des circonstances dans lesquelles la première et la seconde borne électrique ne sont pas opérationnelles.
